Europäisches Patentamt

European Patent Office

Office européen des brevets

(11) Publication number:

**0 316 192**
**A2**

## EUROPEAN PATENT APPLICATION

(21) Application number: 88310653.6

(22) Date of filing: 11.11.88

(51) Int. Cl.⁴: **H 01 L 29/93**
**H 01 L 29/94, H 01 L 27/06**

(30) Priority: 11.11.87 JP 284862/87

(43) Date of publication of application:
17.05.89 Bulletin 89/20

(84) Designated Contracting States: **CH DE FR GB LI**

(71) Applicant: **SEIKO INSTRUMENTS INC.**
**31-1, Kameido 6-chome Koto-ku**
**Tokyo 136 (JP)**

(72) Inventor: **Hattori, Yoshio**
**c/o Seiko Instruments Inc. 31-1 Kameido 6-chome**
**Koto-ku Tokyo (JP)**

(74) Representative: **Caro, William Egerton et al**
**J. MILLER & CO. Lincoln House 296-302 High Holborn**
**London WC1V 7JH (GB)**

(54) Semi-conductor variable capacitance element.

(57) A semi-conductor variable capacitance element electrically
connectable to an external circuit, comprises a semi-conductor
substrate (1) having a major surface and a capacitive region
(15) under the major surface, an insulating film (2) disposed on
the major surface of the semi-conductor substrate, a floating
electrode (3) disposed on the insulating film and electrically
insulated with the semi-conductor substrate (1) through the
insulating film for storing electric charge to build up electrical
potential in the floating electrode according to the stored
amount of electric charge thereby to determine the amount of
the capacitance of the capacitive region (15), a charge control
electrode (7) formed in the semi-conductor substrate for
injecting electric charge from the floating electrode (3) and a
capacitance electrode (5) capacitively coupled to the floating
electrode. Blocking means (4,13) are provided for blocking
application of a DC voltage from the external circuit between
the capacitance electrode (5) and the capacitive region (15) and
a bias means is provided for applying a bias voltage between
the capacitive region and the capacitance electrode.

FIG. 1

## Description

### SEMI-CONDUCTOR VARIABLE CAPACITANCE ELEMENT

This invention relates to semi-conductor variable capacitance elements.

A semi-conductor variable capacitance element is disclosed in "Proceedings Volume 2, 11th International Congress of Chronometry, edited by the French Society of Microtechnology and Chronometry, Page 9, 1984".

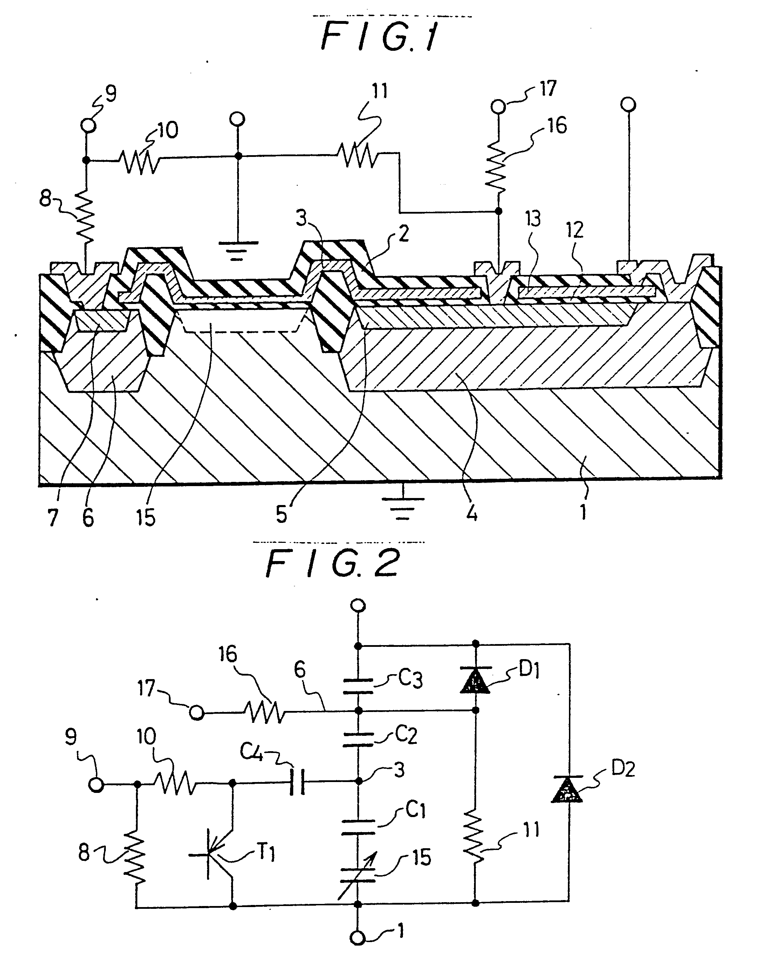

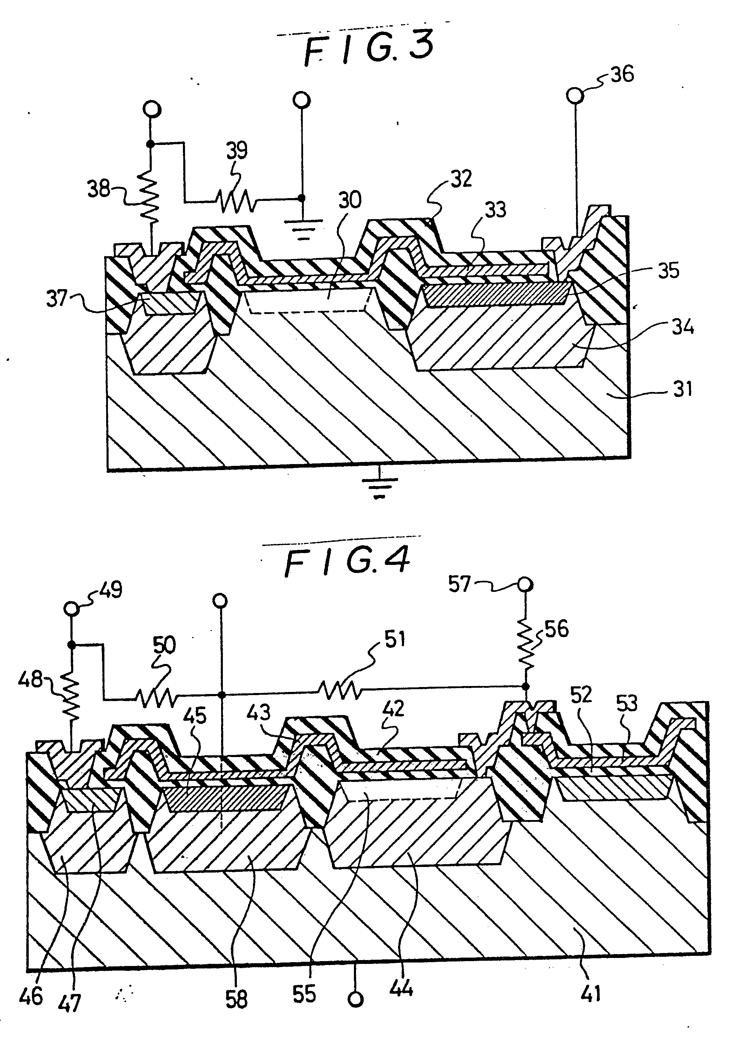

Figure 1 is a sectional view of a conventional semi-conductor variable capacitance element. As shown in Figure 3, the semi-conductor variable capacitance element comprises a p-type semi-conductor substrate 31, a floating electrode 33 disposed on and electrically insulated from the semi-conductor substrate for storing electric charge to form a capacitive region 30 in the semi-conductor substrate, a charge control electrode 37 formed in a portion of the semi-conductor substrate for injecting electric charge into the floating electrode, and a capacitance electrode 35 formed in a portion of the semi-conductor substrate and capacitively coupled to the floating electrode 33. The floating electrode is covered by an insulating film 32 and insulated from the outside. The charge control electrode 37 is composed of a heavily doped P+ region in an n-well diffusion region. The capacitance electrode 35 is composed of a heavily doped n+ region in an n-well diffusion region 34. Resistors 38,39 are protecting resistances for protecting the insulating film 32 from electro-static discharge. The semi-conductor variable capacitance element has a capacitance value between the heavily doped n+ region of the capacitance electrode 35 and the semi-conductor substrate 31. The capacitance value of the semi-conductor variable capacitance element changes in dependance upon an electric potential of the floating electrode 33 produced by the electric charge accumulated therein. A maximum capacitance value thereof is determined by the area of the floating electrode and the area of the capacitance electrode 35 and a minimum capacitance value thereof is determined by the areas and a minimum value of the depletion layer capacitance of the capacitance region 30, i.e. a maximum value of the width of the depletion layer.

In the semi-conductor variable capacitance element of Figure 3, the depletion layer capacitance produced on the surface of the semi-conductor substrate under the floating electrode 33 is controlled by the electric potential of the floating electrode 33 produced by the electric charge accumulated in the floating electrode 33. The floating electrode 33 and the capacitance electrode 35 are strongly capacitively coupled so that the electric potential of the floating electrode 33 is affected by the voltage of the capacitance electrode 35.

Conventionally, since a terminal of the capacitance electrode 35 is connected to an external circuit directly, a bias voltage from the circuit is directly applied to a capacitor electrode 36. Thus, there is a draw-back that when a capacitance value is changed by a change in the bias voltage from the circuit or when the bias voltage from the circuit is high, a high voltage is applied to the p-type diffusion region of the capacitance electrode 35 and the floating electrode 33 so that the accumulated electric charge is changed by a fine tunnel current flowing to the floating electrode 33 and the capacitance value gradually changes with ageing.

In order to overcome the draw-back of conventional semi-conductor variable capacitance elements, the present invention seeks to make the voltage between a floating electrode and a capacitance electrode of a semi-conductor variable capacitance element constant by applying a bias voltage between a capacitive region where a depletion layer is produced by the electric charge accumulated in the floating electrode and the capacitance electrode capacitively coupled to the floating electrode or connecting a resistance between the floating electrode and the capacitance electrode for making a self bias.

With such an arrangement, since a small constant bias voltage can be applied to the floating electrode, the electric potential of the floating electrode is stabilised and leakage current from the floating electrode is restricted, whereby a semi-conductor variable capacitance element having a relatively stable capacitance value without ageing can be realised.

According to the present invention, there is provided a semi-conductor variable capacitance element electrically connectable to an external circuit, comprising: a semi-conductor substrate having a major surface and a capacitive region under the major surface; an insulating film disposed on the major surface of the semi-conductor substrate; a floating electrode disposed on the insulating film electrically insulated from the semi-conductor substrate through the insulating film for storing electric charge to build up an electrical potential in the floating electrode according to the stored amount of electric charge thereby to determine an amount of capacitance of the capacitive region; a charge control electrode formed in the semi-conductor substrate for injecting electric charge into the floating electrode; and a first capacitance electrode capacitively coupled to the floating electrode; characterised by blocking means for blocking an application of a DC voltage from the external circuit between the first capacitance electrode and the capacitive region; and bias means for applying a bias voltage between the capacitive region and the first capacitance electrode.

Preferably the bias means includes a resistor in parallel between the capacitive region and the first capacitance electrode.

In one embodiment the first capacitance electrode is formed in a surface portion of the semi-conductor substrate and comprises a diffusion region of the same conductivity type as that of the semi-conductor substrate.

In another embodiment the first capacitance electrode is formed in a surface portion of the semi-conductor substrate and comprises a heavily doped diffusion region of opposite conductivity type to that of the semi-conductor substrate. The first capacitance electrode may be formed on the floating electrode to the insulating film.

The blocking means may comprise a second capacitance electrode and an MOS capacitance electrode formed in the insulating film. Thus, the second capacitance electrode may be formed under the first capacitance electrode, the second capacitance electrode being of opposite conductivity type to that of the semi-conductor substrate, capacitively coupled to the first capacitance electrode and electrically connected to the MOS capacitance electrode.

The capacitance region may be defined in a surface portion of a well region which is of opposite conductivity type to that of the semi-conductor substrate. In this case the blocking means may comprise a junction capacitance between the well region and the semi-conductor substrate and an MOS capacitance electrode formed in the insulating film, the well region being electrically connected to the MOS capacitance electrode.

In another embodiment the blocking means comprises the first capacitance electrode and an MOS capacitance electrode formed in the insulating film and electrically connected to the first capacitance electrode.

In a further embodiment the blocking means comprises a second capacitance electrode and an MOS capacitance electrode formed in the semi-conductor substrate and electrically connected to the second capacitance electrode. Thus the blocking means may comprise a plurality of MOS capacitance electrodes formed in the insulating film. The second capacitance electrode may be formed in a surface portion of the semi-conductor substrate and comprises a heavily doped diffusion region of opposite conductivity type to that of the semi-conductor substrate.

Preferably the charge control electrode comprises a diffusion region of the same conductivity type to that of the semi-conductor substrate, the diffusion region being formed in a well diffusion region of opposite conductivity type to that of the semi-conductor substrate.

The semi-conductor variable capacitance element may include protective means for protecting the insulating film from electro-static discharge. The protective means may comprise resistance means inserted in parallel between the charge control electrode and the semi-conductor substrate.

The semi-conductor variable capacitance element according to the present invention can provide a stable capacitance value without being affected by an external bias voltage applied to the semi-conductor variable capacitance element by making a direct current voltage constant and by applying this voltage between the capacitive region producing a depletion layer capacitance and the first capacitance electrode which is capacitively coupled to the floating electrode to a thin insulating film.

Moreover, the present invention may provide an excellent semi-conductor variable capacitance element capable of making capacitance value variable by controlling a direct current bias voltage applied between the capacitive region and the first capacitance electrode.

The invention is illustrated, merely by way of example, in the accompanying drawings, in which:

Figure 1 is a sectional view of a first embodiment of a semi-conductor variable capacitance element according to the present invention;

Figure 2 is an equivalent circuit diagram of the semi-conductor variable capacitance element of Figure 1;

Figure 3 is a sectional view of a conventional semi-conductor variable capacitance element;

Figure 4 is a sectional view of a second embodiment of a semi-conductor variable capacitance element according to the present invention;

Figure 5 is an equivalent circuit diagram of the semi-conductor variable capacitance element of Figure 4;

Figure 6 is a sectional view of a third embodiment of a semi-conductor variable capacitance element according to the present invention;

Figure 7 is a sectional view of a fourth embodiment of a semi-conductor variable capacitance element according to the present invention; and

Figure 8 is an equivalent circuit diagram of the semi-conductor variable capacitance element of Figure 7.

Figure 1 is a sectional view of a first embodiment of a semi-conductor variable capacitance element according to the present invention. A floating electrode 3 surrounded by an insulating film 2 and insulated from the outside is deposited on a surface of a semi-conductor substrate 1. A first capacitance electrode 5, which is capacitively coupled with the floating electrode 3 through a thin insulating layer, is formed in a diffusion region of the same conductivity type as that of the semi-conductor substrate 1, on a second capacitance electrode 4. The capacitance electrode 4 is formed in a well diffusion region with conductivity type opposite to that of the semi-conductor substrate 1, on the surface thereof.

A charge control electrode 7 for controlling electric charge accumulated in the floating electrode 3 is formed on the surface of the semi-conductor substrate 1 in a diffusion region of the same conductivity type as that of the semi-conductor substrate 1 in a well diffusion region 6 of conductivity type opposite to that of the semi-conductor substrate 1. The charge control electrode 7 is connected to a capacitance variable terminal 9 through a protection resistor 8 and a capacitance variable terminal 9 and is connected to the semi-conductor substrate 1 to a protection resistor 10. The protection resistors 8,10 are used from protecting the insulating layer surrounding the floating electrode 3 from electro-static charge. The semi-conductor substrate 1 is connected to the first capacitance electrode 5 through a resistor 11 for reducing alternating current.

Further, a MOS capacitance electrode 13 formed through a thin insulating layer 12 on the first capacitance electrode 5 is connected to the second capacitance electrode 4. The second capacitance electrode 4 serves as an external terminal (anode) for taking out a capacitance value of the semi-conductor variable capacitance element. The MOS capacitance electrode 13 and the second capacitance electrode 4 form a direct current cut capacitance for not transmitting a bias voltage imposed on the external terminal (anode) to the semi-conductor substrate 1 and the first capacitance electrode 5.

The capacitance variable electrode 7 is used to control the electric charge accumulated in the floating electrode 3. When a positive or negative high voltage is applied to the capacitance variable terminal 9, a tunnel current is supplied to a very thin insulating layer between the floating electrode 3 and the charge control electrode 7 to cause the electric charge stored in the floating electrode 3 to be changed. A capacitive region 15 of depletion layer capacitance under the major surface of the semi-conductor substrate 1 is changed depending on the electric potential of the floating electrode 3 which changes in accordance with the electric charge accumulated in the floating electrode 3. As a result, a capacitance value (capacitance value between the semi-conductor substrate 1 and the second capacitance electrode 4) of the semi-conductor variable capacitance element can be arbitrarily changed by changing the electric charge accumulated in the floating electrode 3. In addition, since the floating electrode 3 is surrounded by the insulating layer which has excellent dielectric properties (e.g. an oxide layer), the accumulated electric charge does not change with time so long as a variable voltage pulse is not applied to the capacitance variable terminal 9. Therefore, the capacitance value of the semi-conductor variable capacitance element once set does not change so long as a variable voltage pulse is not applied to the capacitance variable terminal 9.

In this embodiment of the present invention, since the first capacitance electrode 5 is connected to the semi-conductor substrate 1 through the resistor 11 and kept at the same electric potential as that of the semi-conductor substrate 1, a direct current bias voltage applied to the external terminal (anode) is only applied to a capacitance composed of a joint capacitance between the first capacitance electrode 5, and the second capacitance electrode and the MOS capacitance electrode 13 and the direct current bias voltage applied to the external terminal (anode) does not affect the electric potential of the floating electrode 3. Consequently, even if the direct current bias voltage applied to the external terminal (anode) changes, the capacitance value of the semi-conductor variable capacitance element once set does not change so long as a variable voltage pulse is not applied to the capacitance variable terminal 9.

The capacitance value of the semi-conductor variable capacitance element of Figure 1 can be arbitrarily changed by changing the electric charge accumulated in the floating electrode 3 by a variable voltage pulse applied to the capacitance variable terminal 9. Concurrently, the capacitance value of the semi-conductor variable capacitance element can also be controlled by a bias voltage applied to a bias terminal 17 and a resistor 16 to control the electric potential of the floating electrode 3. It will be appreciated that the resistor 11 is not always necessary.

Figure 2 is an equivalent circuit diagram of the semi-conductor variable capacitance element of Figure 1. Denoted at C3 is the capacitance of the second capacitance electrode 4 and the first capacitance electrode 5, denoted at C2, is the capacitance of the first capacitance electrode 5 and the floating electrode 3, denoted at C1 is a capacitance between the floating electrode 3 and the thin insulating layer on the surface of the semi-conductor substrate 1, and denoted at 15 is the depletion layer capacitance under the capacitance C1 which is changed by the electric charge stored in the floating electrode 3 on the surface of the semi-conductor substrate 1. Denoted at D1 is a diode for the second capacitance electrode 4 and the first capacitance electrode 5 and denoted at D2 is a diode for the second capacitanoe electrode 4 and the semi-conductor substrate 1. Further, denoted at C4 is the capacitance of a region of the thin insulating layer between the floating electrode 3 and the charge control electrode 7 to which a tunnel current is supplied and T1 is a bi-polar transistor having the variable capacitance electrode 7 as its emitter, the well diffusion region 6 as its base and the semi-conductor substrate 1 as its collector, the base of the transistor T1 floating. The charge control electrode 7 is connected to one side of the resistor 10, whose other side is connected to the capacitance variable terminal 9. The resistor 8 is connected between the capacitance variable terminal 9 and the semi-conductor substrate 1. In addition, the resistor 11 is connected between the first capacitance electrode 5 and the semi-conductor substrate 1 and also connected from the first capacitance electrode 5 to the bias terminal 17 through the resistor 16.

As apparent from the equivalent circuit diagram of Figure 2, since the first capacitance electrode 5 and the semi-conductor substrate 1 are of the same electric potential by being connected through the resistor 11 or they are made constant by the bias voltage applied to the bias terminal 17, a voltage applied to the semi-conductor variable capacitance element of Figure 1 (voltage applied between the second capacitance electrode 4 (anode) and the semi-conductor substrate 1 (cathode)) is applied to the capacitance C3 and the diodes D1, D2 and does not affect the electric potential of the floating electrode 3.

Figure 4 is a sectional view illustrating a second embodiment of a semi-conductor variable capacitance element according to the present invention. A floating electrode 43 covered by a dielectric layer 42 and insulated from the outside is deposited on the surface of a semi-conductor substrate 41 and a first capacitance electrode 45, which is capacitively coupled with the floating electrode 43 through a thin insulating layer, is formed in a well diffusion region 58 of conductivity type opposite to that of the semi-conductor substrate 41, on the surface of the semi-conductor substrate 41. The first capacitance electrode 45 has a high impurity concentration in the surface thereof so as not to produce a depletion layer capacitance by electric charge accumulated in the floating electrode 43.

A well region 44 of opposite conductivity type to that of the semi-conductor substrate 41 is formed in the latter. A capacitive region 55 is defined in the well region 44 by electric charge accumulated in the floating electrode 43, so a depletion layer capacitance is produced. Further, a charge control electrode 47 for controlling electric charge accumulated in the floating electrode 43 is formed on the surface of the semi-conductor substrate 41 in a diffusion region of the same electric conductivity type as that of the semi-conductor substrate 41 in a well diffusion region 46 of conductivity type opposite to that of the semi-conductor substrate 41. The charge control electrode 47 is connected to a capacitance variable terminal 49 through a resistor 48 and the capacitance variable terminal 49 is connected to the first capacitance electrode 45 through a resistor 50. The resistors 48,50 are used for protecting the dielectric layer surrounding the floating electrode 43 from the electro-static charge. The first capacitance electrode 45 is connected to the well region 44 through a resistor 51 and they are of the same direct current potential. Further, a MOS capacitance electrode 53 formed through a thin insulating layer 52 on a surface of the semi-conductor substrate 41 is connected to the second capacitance electrode 44. The semi-conductor substrate 41 serves as an anode for the semi-conductor variable capacitance element in this embodiment. The first capacitance electrode 45 serves as a cathode.

Like the first embodiment of the present invention, the charge control electrode 47 is used to control the electric charge accumulated in the floating electrode 43. When a positive or negative high voltage is applied to the capacitance variable terminal 49, a tunnel current is supplied through a very thin oxide layer between the floating electrode 43 and the charge control electrode 47 to cause the electric charge accumulated in the floating electrode 43 to be changed. A depletion layer capacitance 55 on the surface of the well region 44 is changed depending on the electric potential of the floating electrode 43 which changes in accordance with electric charge accumulated in the floating electrode 43. As a result, the capacitance value (capacitance value between the semi-conductor substrate 41 and the first capacitance electrode 45) of the semi-conductor variable capacitance element of Figure 4 can be arbitrarily changed by changing the electric charge accumulated in the floating electrode 43. In addition, since the floating electrode 43 is surrounded by a dielectric layer having excellent dielectric properties (e.g. an oxide layer), the accumulated electric charge does not change with time so long as a variable voltage pulse is not applied to the capacitance variable terminal 49. Therefore, the capacitance value of the semi-conductor variable capacitance element once set does not change with age so long as a variable voltage pulse is not applied to the capacitance variable terminal 49.

With the semi-conductor variable capacitance element of Figure 4, since the first capacitance electrode 45 is kept at the same potential as the second capacitance electrode 44 by the resistor 55, a direct current bias voltage applied between the semi-conductor substrate 41 and the first capacitance electrode 45 does not affect the electric potential of the floating electrode 43. Consequently, even if the direct current bias voltage applied to the external terminal (anode) changes, the capacitance value of the semi-conductor variable capacitance element once set does not change so long as a variable voltage pulse is not applied to the capacitance variable terminal 49.

The capacitance value of this semi-conductor variable capacitance element can be arbitrarily changed by changing the electric charge accumulated in the floating electrode 43 through the variable voltage pulse applied to the capacitance variable terminal 49. Con currently, the capacitance value of the semi-conductor variable capacitance element can also be controlled by a bias terminal 57 and a resistor 56, the electric potential of the floating electrode 43 being controlled by a bias voltage applied to the bias terminal 57. It will be appreciated that the resistor 51 is not always necessary.

As described above, in the semi-conductor variable capacitance element of Figure 4, blocking means comprises a junction capacitance between the well region 44 and the semi-conductor substrated 41, and the MOS capacitance electrode 53 formed in the insulating film 42. The well region 44 is electrically connected to the MOS capacitance electrode 53.

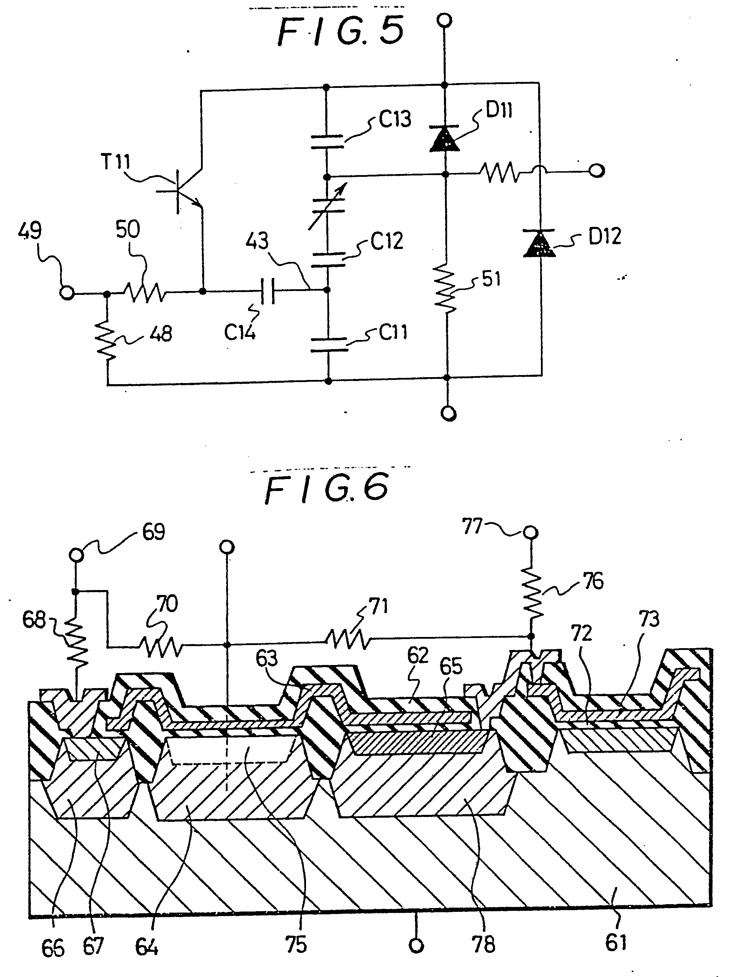

Figure 5 is an equivalent circuit diagram of the semi-conductor variable capacitance element of Figure 4. Denoted at C11 is the capacitance for the first capacitance electrode 45 and the floating electrode 43, denoted at C12, is the capacitance of the floating electrode 43 and the well region 44, and denoted at C13 is the capacitance of the second capacitance electrode 44 and the semi-conductor substrate 41. Denoted at 55 is a depletion layer capacitance of the surface of the well diffusion region of the well region 44 which is changed by the electric charge accumulated in the floating electrode 43. Denoted at D11 is a diode for the well region 44 and the semi-conductor substrate 41 which is connected to the capacitance C13 in parallel. Denoted at 12 is a diode for the first capacitance electrode 45 and the semi-conductor substrate 41. Further, denoted at C14, is the capacitance of the thin dielectric layer between the floating electrode 43 and the charge control electrode 47 to which a tunnel current is supplied. Denoted at T11 is a bi-polar transistor having the charge control electrode 47 as the emitter, the well diffusion region 46 as the base and the semi-conductor substrate 41 as the collector, the base of the transistor T11 floating. The charge control electrode 47 has the resistor 50 connected thereto and to the capacitance variable

5

terminal 49 and the resistor 48 is connected between the capacitance variable terminal 49 and the semi-conductor substrate 41. In addition, the resistor 51 is connected between the first capacitance electrode 45 and the well region 44 and also connected from the first capacitance electrode 45 to the bias terminal 57 through the resistor 56.

As apparent from the equivalent circuit diagram of Figure 5, since the first capacitance electrode 45 and the semi-conductor substrate 41 are of the same electric potential by being connected through the resistor 51 or they are made constant by the bias voltage applied to the bias terminal 57, a voltage applied to the semi-conductor variable capacitance element of Figure 4 (voltage applied between the first capacitance electrode 45 (cathode) and the semi-conductor substrate 41 (anode)) is applied to the capacitance C13 and the diodes D11, D12 and does not affect the electric potential of the floating electrode 43.

Figure 6 is a sectional view illustrating a third embodiment of a semi-conductor variable capacitance element according to the present invention. A floating electrode 63 surrounded by an insulating film 62 and insulated from the outside is deposited on a surface of a semi-conductor substrate 61 and a first capacitance electrode 65, which is capacitively coupled with a floating electrode 63 through a thin insulating layer, is formed on the surface of the semi-conductor substrate 61 in a well diffusion region 78 of conductivity type opposite to that of the semi-conductor substrate 61. The first capacitance electrode 65 has a high impurity concentration in the surface thereof so as not to produce a depletion layer capacitance by electric charge accumulated in the floating electrode 63.

A well region 64 of opposite conductivity type to that of the semi-conductor substrate 61 is formed in the semi-conductor substrate. A capacitive region 75 is defined in the well region 64 by electric charge accumulated in the floating electrode 63, so a depletion layer capacitance is produced. Further, a charge control electrode 67 for controlling electric charge accumulated in the floating electrode 63 is formed on the surface of the semi-conductor substrate 61 in a diffusion region of the same conductivity type as that of the semi-conductor substrate 61 in a well diffusion region 66 of conductivity type opposite to that of the semi-conductor substrate 61. The charge control electrode 67 is connected to a capacitance variable terminal 69 through a resistor 68 and the capacitance variable terminal 69 is connected to the well region 64 through a resistor 70. The resistors 68,70 are used for protecting the insulating layer surrounding the floating electrode 63 from electro-static discharge. The first capacitance electrode 65 is connected to the well region 64 through a resistor 71 and they are of the same direct current potential. Further, a MOS capacitance electrode 73 formed through a thin insulating layer 72 on a surface of the semi-conductor substrate 61 is connected to the first capacitance electrode 65. The semi-conductor substrate 61 serves as an anode for the semi-conductor variable capacitance element. The well region 64 serves as a cathode.

Like the second embodiment of the present invention illustrated Figure 4, the charge control electrode 67 is used to control the electric charge accumulated in the floating electrode 63. When a positive or negative high voltage is applied to the capacitance variable terminal 69, a tunnel current is supplied to a very thin dielectric layer between the floating electrode 63 and the capacitance variable electrode 67 to cause electric charge accumulated in the floating electrode 63 to change. A depletion layer capacitance of the capacitive region 75 is changed depending on the electric potential of the floating electrode 63 which changes in accordance with the electric charge accumulated in the floating electrode 63. As a result, the capacitance value (capacitance between the semi-conductor substrate 61 and the well region 64) of the semi-conductor variable capacitance element can be arbitrarily changed by changing the electric charge accumulated in the floating electrode 63. In addition, since the floating electrode 63 is surrounded by an insulating layer having excellent dielectric properties (e.g. an oxide layer), the accumulated electric charge does not change with age so long as a variable voltage pulse is not applied to the capacitance variable terminal 69. Therefore, the capacitance value of the semi-conductor variable capacitance element once set does not change with time so long as a variable voltage pulse is not applied to the capacitance variable terminal 69.

In this embodiment, since the first capacitance electrode 65 is kept at the same electric potential as the well region 64 by the resistor 71, a direct current bias voltage applied between the semi-conductor substrate 61 and the well region 64 does not affect the electric potential of the floating electrode 63. Consequently, even if the direct current bias voltage applied to the external terminal (anode) changes, the capacitance value once set at the semi-conductor variable capacitance element does not change so long as the variable voltage pulse is not applied to the capacitance variable terminal 69.

The capacitance value of the semi-conductor variable capacitance element can be arbitrarily changed by changing the electric charge accumulated in the floating electrode 63 by a variable voltage pulse applied to the capacitance variable terminal 69. Concurrently, the capacitance value of the semi-conductor variable capacitance element can also be controlled by a bias terminal 77 and a resistor 76, the electric potential of the floating electrode 63 being controlled by a bias voltage applied to the bias terminal 67. It will be appreciated that the resistor 71 may not be necessary.

As described above, in the semi-conductor variable capacitance element of Figure 6 blocking means for blocking application of a DC voltage from the external circuit comprises the first capacitance electrode 65 and the MOS capacitance electrode 73 formed in the insulating film 62. The MOS capacitance electrode 73 is connected to the first capacitance electrode 65.

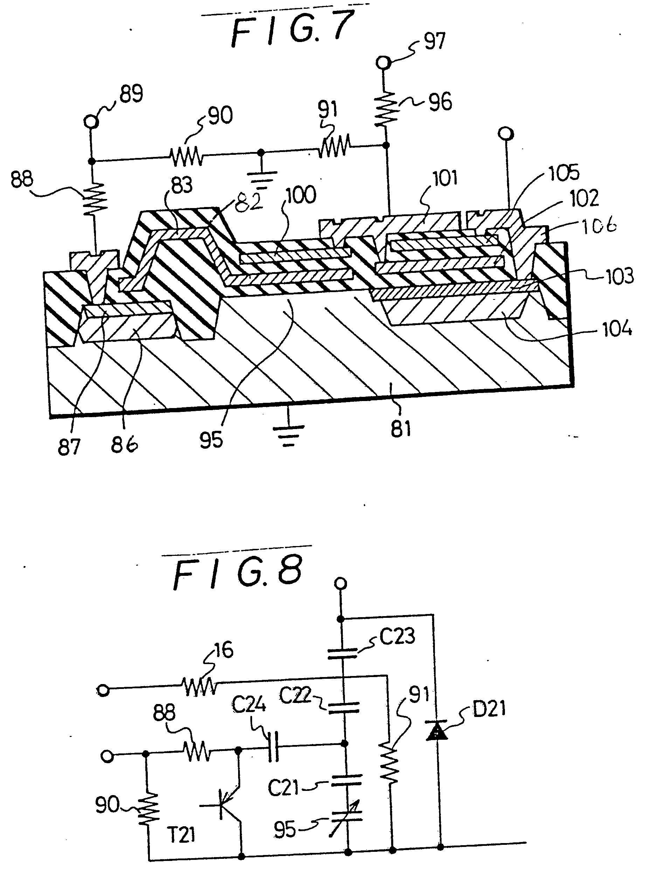

Figure 7 is a sectional view of a fourth embodiment of a semi-conductor variable capacitance element according to the present invention. A floating electrode 83 covered by an insulating film 82 and insulated from the outside is provided on the surface of a semi-conductor substrate 81 and there is formed a first capacitive electrode 100 which is capacitively coupled with the floating electrode 83 through a thin insulating layer. The first capacitance electrode 100 is connected to a MOS capacitance electrode 102 through wiring 101. A second capacitance electrode 103 made of a heavily doped diffusion region which is of opposite conductivity type to that of the semi-conductor substrate 81 is formed in a well diffusion region 104 of opposite conductivity type to that of the semi-conductor substrate 81. The second capacitance electrode 103 is provided under the surface of the semi-conductor substrate 81 through the thin insulating layer. The well diffusion region 104 is provided in order to reduce junction capacitance between the second capacitance electrode 103 and the semi-conductor substrate 81.

Further, a MOS capacitance electrode 105 is formed on the electrode 102 through a thin insulating layer, and electrode 105 is connected to the second capacitance electrode 103 through wiring 106. Further, a charge control electrode 87 for controlling electric charge accumulated in the floating electrode 83 is formed on the surface of the semi-conductor substrate 81 in a diffusion region of the same conductivity type as the semi-conductor substrate 81 in a well diffusion region 86 of conductivity type opposite to that of the semi-conductor substrate 81. The charge control electrode 87 is connected to a capacitance variable terminal 89 through a resistor 88 and the capacitance variable terminal 89 is connected to the semi-conductor substrate 81 through a resistor 90. The resistors 88,90 are used for protecting the insulating layer surrounding the floating electrode 83 from electro-static discharge. In addition, the semi-conductor substrate 81 is connected to the first capacitance electrode 100 through a resistor 91 for blocking alternating current. The second capacitance electrode 103 is comprised of a blocking means for blocking a bias voltage applied to the second capacitance electrode 103 to the semi-conductor substrate 81 and the first capacitance electrode 100.

The charge control electrode 87 is used to control the electric charge accumulated in the floating electrode 83. When a positive or negative high voltage is applied to the capacitance variable terminal 89, a tunnel current is supplied to a very thin dielectric layer between the floating electrode 83 and the charge control electrode 87 to cause the electric charge accumulated in the floating electrode 83 to be changed. A depletion layer capacitance of a capacitive region 95 on the surface of the semi-conductor substrate 81 is changed depending on the electric potential of the floating electrode 83 which changes in accordance with the electric charge accumulated in the floating electrode 83. As a result, the capacitance value (capacitance between the semi-conductor substrate 81 and the second capacitance electrode 103) of the semi-conductor variable capacitance element can be arbitrarily changed by changing the electric charge accumulated in the floating electrode 83. In addition, since the floating electrode 83 is surrounded by an insulating layer having excellent dielectric properties (e.g. an oxide layer), the accumulated electric charge does not change with time so long as a variable voltage pulse is not applied to the capacitance variable terminal 89. Therefore, the capacitance value of the semi-conductor variable capacitance element once set does not change so long as a variable voltage pulse is not applied to the capacitance variable terminal 89.

The capacitance value of the semi-conductor variable capacitance element of Figure 7 can be arbitrarily changed by changing the electric charge accumulated in the floating electrode 83 to a variable voltage pulse applied to the capacitance variable terminal 89. Concurrently, the capacitance value can also be controlled by a bias terminal 97 and a resistor 96, the electric potential of the floating electrode 83 being controlled by a bias voltage applied to the bias terminal 97. It will be appreciated that the resistor 96 may not be necessary.

Figure 8 is an equivalent circuit diagram of the semi-conductor variable capacitance element of Figure 8. Denoted at C21 is the capacitance of the thin insulating layer between the floating electrode 83 and the semi-conductor substrate 81 and denoted at 95 is a depletion layer capacitance of the surface of the semi-conductor substrate under the capacitance C21 which is changed by the electric charge accumulated in the floating electrode 83. Denoted at C22 is the capacitance of the first capacitance electrode 85 and the floating electrode 83, denoted at C23 is the capacitance of the second capacitance electrode 103 and the first capacitance electrode 85, and denoted at D21 is a diode for the diffusion region of the second capacitance electrode 103 and the semi-conductor electrode 81. Further, denoted at C24, is the capacitance of a region of the thin dielectric layer between the floating electrode 83 and the charge control electrode 87 to which tunnel current is supplied, and T21 is a bi-polar transistor having the charge control electrode 87 as the emitter, the well diffusion region 86 as the base and the semi-conductor substrate as the collector, the base of the transistor T21 floating.

The charge control electrode 87 is connected via the resistor 90 to the capacitance variable terminal 89 and the resistor 88 is connected between the variable terminal 89 and the semi-conductor substrate 81. In addition, the resistor 91 is connected between the first capacitance electrode 100 and the semi-conductor substrate 81 and also connected from the first capacitance electrode 100 to the bias terminal 97 through the resistor 96.

As will be appreciated from the equivalent circuit diagram of Figure 8, since the first capacitance electrode 100 and the semi-conductor substrate 81 are of the same electric potential by being connected through the resistor 91 or they are made constant by the bias voltage applied to the bias terminal 97, a voltage applied to the semi-conductor variable capacitance element (voltage applied between the first capacitance electrode 103 and the semi-conductor substrate 81) is applied to the capacitance C23 and the diodes D21 and does not affect the electric potential of the floating electrode 83.

## Claims

1. A semi-conductor variable capacitance element electrically connectable to an external circuit, comprising: a semi-conductor substrate (1;41;61;81) having a major surface and a capacitive region (15;55;75;95) under the major surface; an insulating film (2;42;62;82) disposed on the major surface of the semi-conductor substrate; a floating electrode (3;43;63;83) disposed on the insulating film (2;42;62;82) electrically insulated from the semi-conductor substrate (1;41;61;81) through the insulating film for storing electric charge to build up an electrical potential in the floating electrode according to the stored amount of electric charge thereby to determine an amount of capacitance of the capacitive region (15;55;75;95); a charge control electrode (7;47;67;87) formed in the semi-conductor substrate (1;41;61;81) for injecting electric charge into the floating electrode (3;43;63;83); and a first capacitance electrode (5;45;65;100) capacitively coupled to the floating electrode; characterised by blocking means (4,13; 44,53; 65,73;102,103,105) for blocking an application of a DC voltage from the external circuit between the first capacitance electrode (5;45;65;100) and the capacitive region (15;55;75;95); and bias means (16,17; 56,57; 76,77; 96,97) for applying a bias voltage between the capacitive region and the first capacitance electrode (5;45;65;100).

2. A semi-conductor variable capacitance element as claimed in claim 1 characterised in that the bias means includes a resistor (16;56;76;96) in parallel between the capacitive region (15;55;75;95) and the first capacitance electrode (5;45;65;85).

3. A semi-conductor variable capacitance element as claimed in claim 1 or 2, characterised in that the first capacitance electrode (5) is formed in a surface portion of the semi-conductor substrate (1) and comprises a diffusion region of the same conductivity type as that of the semi-conductor substrate.

4. A semi-conductor variable capacitance element as claimed in claim 1 or 2, characterised in that the first capacitance electrode (100) is formed in a surface portion of the semi-conductor substrate (81) and comprises a heavily doped diffusion region of opposite conductivity type to that of the semi-conductor substrate.

5. A semi-conductor variable capacitance element as claimed in any of claims 1, 2 or 4 characterised in that the first capacitance electrode (100) is formed on the floating electrode (83) to the insulating film (82).

6. A semi-conductor variable capacitance element as claimed in any of claims 1 to 3, characterised in that the blocking means comprises a second capacitance electrode (4) and an MOS capacitance electrode (13) formed in the insulating film (2).

7. A semi-conductor variable capacitance element as claimed in claim 6 characterised in that the second capacitance electrode (4) is formed under the first capacitance electrode (5), the second capacitance electrode (4) being of opposite conductivity type to that of the semi-conductor substrate (1), capacitively coupled to the first capacitance electrode (5) and electrically connected to the MOS capacitance electrode (13).

8. A semi-conductor variable capacitance element as claimed in claim 1 or 2, characterised in that the capacitive region (55) is defined in a surface portion of a well region (44) which is of opposite conductivity type to that of the semi-conductor substrate (41).

9. A semi-conductor variable capacitance element as claimed 8, characterised in that the blocking means comprises a junction capacitance between the well region (44) and the semi-conductor substrate (41) and an MOS capacitance electrode (53) formed in the insulating film (42), the well region (44) being electrically connected to the MOS capacitance electrode (53).

10. A semi-conductor variable capacitance element as claimed in claim 1 or 2, characterised in that the blocking means comprises the first capacitance electrode (65) and an MOS capacitance electrode (73) formed in the insulating film (62) and electrically connected to the first capacitance electrode (65).

11. A semi-conductor variable capacitance element as claimed in any of claims 1, 2, 4 or 5, characterised in that the blocking means comprises a second capacitance electrode (103) and an MOS capacitance electrode (102,105) formed in the semi-conductor substrate (81) and electrically connected to the second capacitance electrode (103).

12. A semi-conductor variable capacitance element as claimed in any of claims 1, 2, 4, 5 or 11, characterised in that the blocking means comprises a plurality of MOS capacitance electrodes (102,105) formed in the insulating film (82).

13. A semi-conductor variable capacitance element as claimed in claim 11 or 12, characterised in that the second capacitance electrode (103) is formed in a surface portion of the semi-conductor substrate (81) and comprises a heavily doped diffusion region of opposite conductivity type to that of the semi-conductor substrate.

14. A semi-conductor variable capacitance element as claimed in any preceding claim, characterised in that the charge control electrode (7;47;67;87) comprises a diffusion region of the same conductivity type to that of the semi-conductor substrate, the diffusion region being formed in a well diffusion region (6;46;66;86) of opposite conductivity type to that of the semi-conductor substrate (1;41;61;81).

15. A semi-conductor variable capacitance element as claimed in any preceding claim characterised by including protective means (8,10; 48,50; 68,70; 88,90) for protecting the insulating film (2;42;62;82) from electro-static discharge.

16. A semi-conductor variable capacitance element as claimed in claim 15, characterised in that the protective means comprises resistance means (8,10;48,50; 68,70; 88,90) inserted in parallel between the charge control electrode (7;47;67;87) and the semi-conductor substrate (1;41;61;81).

*F I G. 1*

*F I G. 2*

# FIG.3

36

39

38

32

33

30

35

37

34

31

# FIG.4

49

57

50

51

56

48

45

43

42

52

53

46 47

58

55

44

41

## FIG. 5

## FIG. 6

# FIG. 7

# FIG. 8